# EUROPÄISCHE PATENTANMELDUNG

(11) **EP 2 339 047 A1**
(43) Veröffentlichungstag der Anmeldung: **29.06.2011**
(21) Anmeldenummer: 10194939.4
(22) Anmeldetag: 14.12.2010
(51) Int. Cl.: C23C 14/54, C23C 14/56, C23C 16/54

(54) **Anordnung zum Temperieren von bandförmigen Substraten**

(30) Priorität: 14.12.2009 DE 102009058038
(71) Anmelder: FHR Anlagenbau GmbH, 01458 Ottendorf-Okrilla (DE)
(72) Erfinder: Kreher, Sascha, 01219, Dresden (DE); Rudin, Mark, 01257, Dresden (DE); Köhler, Lutz, 01445 Radebeul (DE); Gawer, Olaf, 01328, Dresden (DE)
(74) Vertreter: Lippert, Stachow & Partner

(57) **Zusammenfassung**

Die Erfindung betrifft eine Anordnung zum Temperieren von bandförmigen Substraten, beispielsweise in einer Vakuumbeschichtungsanlage, insbesondere für Dünnfilmanwendungen.

Durch die Erfindung soll eine Anordnung zur Temperierung eines bandförmigen Substrates geschaffen werden, mit der eine besonders homogene Schichtverteilung auf der Oberfläche des Substrates erreicht und eine besonders gute Ausbeute des Beschichtungsmateriales gewährleistet wird.

Erreicht wird das dadurch, dass das zu beschichtende bandförmige Substrat (5) frei gespannt über einer Verdampferquelle (1) durch eine Prozessanlage (7) geführt ist und dort über der Verdampferquelle (1) zumindest mittelbar über ein fest stehendes größeres Masseelement im Wärmeleitkontakt, in Form eines temperierten Blocks (2), an dem das bandförmige Substrat (5) entlang gleitet, geführt wird. (Fig.)

## Beschreibung

Die Erfindung betrifft eine Anordnung zum Temperieren von bandförmigen Substraten, beispielsweise in einer Vakuumbeschichtungsanlage, insbesondere für Dünnfilmanwendungen.

Zur Herstellung von Dünnschicht-Solarzellen oder anderen Dünnschichtanwendungen werden bandförmige Substrate, die beispielsweise aus Kunststoffen bestehen, mit Dünnschichten in Vakuumanlagen mittels CVD- oder Sputterprozessen, oder durch Bedampfen beschichtet, wobei diese in der Regel prozessbedingt mit einer Wärmebelastung beaufschlagt werden. Diese Wärmebelastung ergibt sich aus der während der Kondensation des Beschichtungsmaterials auf dem Substrat frei werdenden Wärmeenergie, als auch aus einer Strahlungsbelastung, die u.a. durch temperierte Verdampferquellen für das Beschichtungsmaterial hervorgerufen werden.

Die Beschichtung von bandförmigen Substraten erfolgt allgemein an temperierten Walzen, indem dieses über Walzen geleitet wird, oder im so genannten "free-span", d.h. frei gespannt, bei dem das bandförmige Substrat ohne Walzenkontakt durch die Vakuumbeschichtungsanlage geführt wird.

Eine Alternative zeigt die EP 2 096 190 A1, bei der das bandförmige Substrat über ein synchron mit dem Substrat angetriebenes Endlosband ohne Walzenkontakt durch einen Beschichtungsbereich einer Vakuumbeschichtungsanlage geführt wird, das zwischen zwei flüssigkeitsgefüllten Walzen gespannt ist, von denen eine mit einem Antrieb verbunden ist. Das Endlosband ist wärmeleitfähig oder zumindest teilweise wärmeleitfähig und besteht aus Metall oder einem leitfähigen Material. Zusätzlich kann im Bereich innerhalb des Endlosbandes, oder dieses selbst, mit einer elektrischen Heizung versehen sein.

Die Entscheidung, welche Beschichtungsart gewählt wird, hängt von der Energiebilanz und den maximal zulässigen Temperaturen am bandförmigen Substrat ab. Diese Faktoren werden sowohl von der Geometrie der Verdampferquelle als auch von der Geometrie des Substrates über der Verdampferquelle bestimmt.

Als günstig erweist sich hier die Führung und Beschichtung des Substrates im "free-span" oder auch durch Führen über das Endlosband entsprechend der EP 2 096 190 A1, da die Abstände diskreter Punkte auf dem Substrat im Beschichtungsbereich im Mittel näher an der Verdampferquelle liegen, als beim Beschichten an einer Walze mit endlichem Durchmesser.

Von Nachteil ist hierbei allerdings die deutlich schlechtere Temperierbarkeit des bandförmigen Substrates. Insbesondere kann im Beschichtungsbereich keine gleichmäßige Temperaturverteilung auf dem Substrat gewährleistet werden.

Der Erfindung liegt nun die Aufgabe zugrunde, eine Anordnung zur Temperierung eines bandförmigen Substrates, beispielsweise in einer Vakuumbeschichtungsanlage, insbesondere für Dünnfilmanwendungen, zu schaffen, mit der eine besonders homogene Schichtverteilung auf der Oberfläche des Substrates erreicht und eine besonders gute Ausbeute des Beschichtungsmateriales gewährleistet wird.

Die der Erfindung zugrunde liegende Aufgabe wird bei einer Vorrichtung der eingangs genannten Art dadurch gelöst, dass das zu beschichtende bandförmige Substrat frei gespannt über einer Verdampferquelle durch eine Prozessanlage geführt wird und dort über der Verdampferquelle zumindest mittelbar über ein fest stehendes größeres Masseelement im Wärmeleitkontakt geführt wird. Damit lassen sich die Vorteile eines frei gespannten Substrates mit denen einer Walze endlichen Durchmessers auf besonders einfache Weise miteinander vereinen.

In einer ersten Ausgestaltung der Erfindung ist das Masseelement ein temperierter Block, an dem das bandförmige Substrat entlang geführt wird.

Es ist von besonderem Vorteil, wenn der temperierte Block in Richtung zur Verdampferquelle unter diesem in einem gleichmäßigen Bogen nach unten gewölbt ist, oder zumindest im Kontaktbereich zum bandförmigen Substrat mit einer konvex gekrümmten Kontur versehen ist. Auf diese Weise kann das bandförmige Substrat besonders nahe an der Verdampferquelle vorbei geführt werden, wodurch das zu verdampfende Material noch effektiver ausgenutzt werden kann.

Der temperierte Block kann eine Temperiereinrichtung, wie einer elektrischen Heizung, aufweisen oder mit einem Heiz-/Kühlkreislauf verbunden sein.

Um das bandförmige Substrat möglichst reibungsfrei über den temperierten Block zu führen, wird zwischen diesem und dem bandförmigen Substrat ein synchron mit dem bandförmigen Substrat angetriebenes Endlosband über den temperierten Block geführt.

Das Endlosband kann einfach zwischen zwei neben dem temperierten Block gelagerten Umlenkrollen geführt werden, wobei eine der Umlenkrollen zugleich mit einem Antrieb gekoppelt ist.

Um auch bei unterschiedlichen Prozesstemperaturen eine ausreichende Spannung zu erreichen, ist dem Endlosband eine Spanneinrichtung zugeordnet.

Das Endlosband sollte aus einem temperaturbeständigen gut Wärme leitenden Material bestehen.

Das Endlosband kann aus Metall oder einem beispielsweise vernetzten Kunststoff bestehen und sollte möglichst dünn sein, um eine schnelle Wärmeübertragung vom temperierten Block zum bandförmigen Substrat zu gewährleisten.

In einer weiteren Ausgestaltung der Erfindung sind das Endlosband und/oder der temperierte Block zumindest im Kontaktbereich mit dem Endlosband mit einer Beschichtung zur Verminderung der Partikelgeneration und/oder Reibung zwischen dem temperierten Block und dem Endlosband versehen.

Die Erfindung soll nachfolgend an einem Ausführungsbeispiel näher erläutert werden. Die zugehörige Zeichnung zeigt eine schematische Darstellung einer erfindungsgemäßen Anordnung zur Temperierung eines bandförmigen Substrates.

Entsprechend der Zeichnungsfigur befindet sich die Anordnung zur Temperierung eines bandförmigen Substrates 5 in einer Prozesskammer 7. Eine solche Prozesskammer 7, die aus Metall, Quarzglas, Graphit oder einem anderen Material bestehen kann, kann eine Verdampfungskammer, eine CVD- oder PECVD-Vakuumprozesskammer, eine Sputterkammer o.dgl. mit Medienzu- und -ableitung sowie mit einer geeigneten Heizung sein. Als bandförmiges Substrat kann jedes beliebige zu beschichtende Band aus Kunststoff oder Metall in Betracht kommen und auch die Art und Weise der Beschichtung mit ein-oder mehrschichtiger Struktur kann vollkommen frei gewählt werden.

In der Prozesskammer 7 befindet sich im zeichnungsgemäß unteren Bereich eine Verdampferquelle 1, welche das auf dem bandförmigen Substrat abzuscheidende Material bereitstellt. Diese Verdampferquelle 1 kann mit einer eigenen Heizung versehen sein, oder indirekt über die Heizung der Prozesskammer 7 mit erwärmt werden.

Das zu beschichtende Substrat 5 wird nun in der Prozesskammer 7 über einen massereichen temperierten und fest stehenden Block 2 geführt, wobei das bandförmige Substrat 5 dabei gleichzeitig durch Wärmeleitung auf die erforderliche Abscheidetemperatur temperiert wird. Der temperierte Block 2 kann aus Metall, oder einem anderen geeigneten Material bestehen und kann zusätzlich zumindest im Kontaktbereich mit dem zu beschichtenden bandförmigen Substrat mit einer die Reibung und/oder die Partikelgeneration vermindernden Beschichtung versehen sein.

Der temperierte Block 2 befindet sich in einem vorgegebenen Abstand über der Verdampferquelle und ist in Richtung zur Verdampferquelle 1 in einem gleichmäßigen Bogen nach unten gewölbt in einer leicht konvex gekrümmten Kontur ausgeführt.

Auf diese Weise wird eine gleichmäßige Anlage des bandförmigen Substrats 5 am temperierten Block 2 gewährleistet, wenn dieses darüber geleitet wird.

Der temperierte Block 2 ist mit einer Temperiereinrichtung, wie einer elektrischen Heizung, versehen oder mit einem Heiz-/Kühlkreislauf 10 verbunden, so dass dieser auf die erforderliche Temperatur erwärmt bzw. gekühlt werden kann.

Das bandförmige Substrat 5 kann über eine Bandschleuse 8 in einer Wand der Prozesskammer 7 in diese hinein und über eine weitere Bandschleuse 8' in der gegenüber liegenden Wand der Prozesskammer 7 aus dieser herausgeschleust werden. Für die Führung und Spannung des bandförmigen Substrates 5 dienen außerhalb der Prozesskammer 7 befindliche Führungs- und Spanneinrichtungen in Form einer Abwickelvorrichtung 9, z.B. eine Vorratsrolle, und eine Aufwickelvorrichtung 9'.

Alternativ kann als Führungseinrichtung für das bandförmige Material 5 in der Prozesskammer 7 auch ein Endlosband 3 vorgesehen sein, das über zwei Umlenkrollen 4, 4' neben dem temperierten Block 2 direkt über den temperierten Block 2 geführt wird, wobei das bandförmige Substrat 5 dann über das Endlosband 3 auf dem temperierten Block 2 geführt wird. Damit wird jegliche Relativbewegung des bandförmigen Substrates 5 gegenüber einer Führungseinrichtung in der Prozesskammer 7 vermieden.

Von den zwei Umlenkrollen 4, 4' neben dem temperierten Block 2 ist zumindest eine Umlenkrolle 4, 4' mit einem Antrieb gekoppelt. Um auch bei unterschiedlichen Prozesstemperaturen eine ausreichende Spannung zu erreichen, kann dem Endlosband 3 eine Spanneinrichtung 6 zugeordnet sein.

Das Endlosband 3 muss aus einem temperaturbeständigen gut Wärme leitenden Material mit geringer Wärmekapazität bestehen. Das ist notwendig, um eine schnelle Temperierung des über den temperierten Block 2 geleiteten bandförmigen Substrates 5 zu gewährleisten. Beispielsweise kann das Endlosband 3 aus Metall oder einem vernetzten Kunststoff oder anderen Kunststoff bestehen. Auf diese Weise kann im Beschichtungsbereich eine gleichmäßige Temperaturverteilung auf dem Substrat gewährleistet werden.

Schließlich ist es möglich, das Endlosband 3 und/oder den temperierten Block 2 zumindest im Kontaktbereich mit dem Endlosband 3 mit einer Beschichtung zu versehen, um die Partikelgeneration infolge Reibung zu vermindern.

### Anordnung zum Temperieren von bandförmigen Substraten

### Bezugszeichenliste

- 1: Verdampferquelle
- 2: temperierter Block
- 3: Endlosband
- 4: Umlenkrolle
- 4': Umlenkrolle
- 5: bandförmiges Substrat
- 6: Spanneinrichtung
- 7: Prozesskammer
- 8: Bandschleuse
- 8': Bandschleuse
- 9: Abwickelvorrichtung (Vorratstrommel)
- 9': Aufwickelvorrichtung

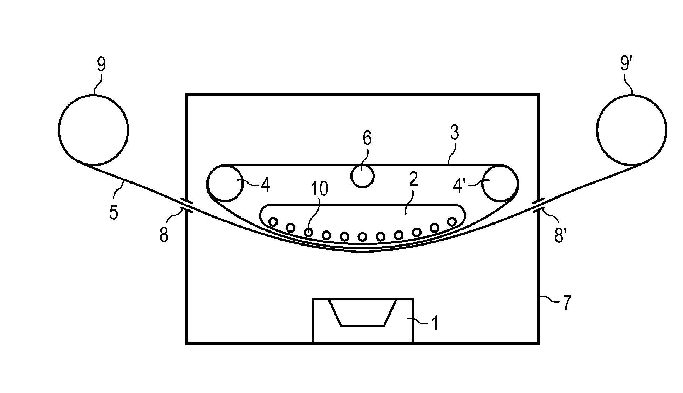

## Patentansprüche

1. Anordnung zum Temperieren von bandförmigen Substraten, beispielsweise in einer Vakuumbeschichtungsanlage, insbesondere für Dünnfilmanwendungen, **dadurch gekennzeichnet, dass** das zu beschichtende bandförmige Substrat (5) frei gespannt über einer Verdampferquelle (1) durch eine Prozessanlage (7) geführt ist und dort über der Verdampferquelle (1) zumindest mittelbar über ein fest stehendes größeres Masseelement im Wärmeleitkontakt geführt wird.

2. Anordnung nach Anspruch 1, **dadurch gekennzeichnet, dass** das Masseelement ein temperierter Block (2) ist, an dem das bandförmige Substrat (5) entlang führbar ist.

3. Anordnung nach Anspruch 2, **dadurch gekennzeichnet, dass** der temperierte Block (2) in Richtung zur Verdampferquelle (1) in einem gleichmäßigen Bogen nach unten gewölbt ist.

4. Anordnung nach Anspruch 3, **dadurch gekennzeichnet, dass** der temperierte Block (2) zumindest im Kontaktbereich zum bandförmigen Substrat (5) eine konvex gekrümmte Kontur aufweist.

5. Anordnung nach Anspruch 3 und 4, **dadurch gekennzeichnet, dass** der temperierte Block (2) mit einer Temperiereinrichtung, wie einer elektrischen Heizung, versehen oder mit einem Heiz-/Kühlkreislauf verbunden ist.

6. Anordnung nach einem der Ansprüche 1 bis 5, **dadurch gekennzeichnet, dass** zwischen dem temperierten Block (2) und dem bandförmigen Substrat (5) ein synchron angetriebenes Endlosband (3) über diesen geführt ist.

7. Anordnung nach Anspruch 6, **dadurch gekennzeichnet, dass** das Endlosband (3) zwischen zwei Umlenkrollen (4, 4') neben dem temperierten Block (2) geführt ist, von denen zumindest eine Umlenkrolle (4, 4') mit einem Antrieb gekoppelt ist.

8. Anordnung nach Anspruch 7, **dadurch gekennzeichnet, dass** dem Endlosband (3) eine Spanneinrichtung zugeordnet ist.

9. Anordnung nach einem der Ansprüche 1 bis 7, **dadurch gekennzeichnet, dass** das Endlosband (3) aus einem temperaturbeständigen gut Wärme leitenden Material mit geringer Wärmekapazität besteht.

10. Anordnung nach Anspruch 9, **dadurch gekennzeichnet, dass** das Endlosband (3) aus Metall oder einem vernetzten Kunststoff besteht.

11. Anordnung nach Anspruch 9, **dadurch gekennzeichnet, dass** das das Endlosband (3) und/oder der temperierte Block zumindest im Kontaktbereich mit dem Endlosband (3) mit einer Beschichtung versehen ist.
